# EUROPEAN PATENT APPLICATION

(11) **EP 2 922 102 A1**
(43) Date of publication of application: **23.09.2015**
(21) Application number: 15156997.7
(22) Date of filing: 27.02.2015
(51) Int. Cl.: H01L 33/16, H01L 33/38, H01L 33/32, H01L 33/40, H01L 33/00

(54) **SEMICONDUCTOR LIGHT EMITTING ELEMENT**

(30) Priority: 17.03.2014 JP 2014054157
(71) Applicant: Kabushiki Kaisha Toshiba, Tokyo 105-8001 (JP)
(72) Inventor: Ito, Toshihide, Tokyo, 105-8001 (JP); Ono, Hiroshi, Tokyo, 105-8001 (JP); Nunoue, Shinya, Tokyo, 105-8001 (JP)
(74) Representative: Granleese, Rhian Jane

(57) **Abstract**

According to one embodiment, a semiconductor light emitting element (110, 111) includes a first electrode (51), a first semiconductor layer (10), a light emitting layer (30), a second semiconductor layer (20), a first insulating portion (41), and a first conductive layer (55). The first electrode (51) includes first and second regions (R1, R2). The first semiconductor layer (10) is separated from the first region (R1), and includes first and second portions (11, 12). The light emitting layer (30) is provided between the second portion (12) and the first region (R1). The second semiconductor layer (20) is provided between the light emitting layer (30) and the first region (R1). The second electrode (62) is provided between the first region (R1) and the second semiconductor layer (20) to contact the second semiconductor layer (20). The first insulating portion (41) is provided between the first region (R1) and the second electrode (62). The first conductive layer (55) is provided between the first portion (11) and the first region (R1), and includes a contact portion (55c) contacting the first portion (11).

## Description

### FIELD

Embodiments described herein relate generally to a semiconductor light emitting element.

### BACKGROUND

It is desirable to increase the efficiency of semiconductor light emitting elements such as LEDs (Light Emitting Diodes), etc.

### BRIEF DESCRIPTION OF THE DRAWINGS

FIG. 1 is a schematic cross-sectional view showing a semiconductor light emitting element according to an embodiment;
FIG. 2 is a schematic plan view showing the semiconductor light emitting element according to the embodiment;
FIG. 3 is a schematic cross-sectional view showing a portion of the semiconductor light emitting element according to the embodiment;
FIG. 4A to FIG. 4C are schematic cross-sectional views in order of the processes, showing a method for manufacturing the semiconductor light emitting element according to the embodiment;
FIG. 5A, and FIG. 5B are schematic cross-sectional views in order of the processes, showing a method for manufacturing the semiconductor light emitting element according to the embodiment;
FIG. 6 is a schematic cross-sectional view showing another semiconductor light emitting element according to the embodiment;
FIG. 7 is a graph of characteristics of the semiconductor light emitting element according to the embodiment;
FIG. 8 is a graph of characteristics of the semiconductor light emitting element according to the embodiment;
FIG. 9 is a schematic cross-sectional view showing a portion of a semiconductor device according to the embodiment; and
FIG. 10 is a schematic cross-sectional view showing a light emitting device using the semiconductor light emitting element according to the embodiment.

### DETAILED DESCRIPTION

According to one embodiment, a semiconductor light emitting element includes a first electrode, a first semiconductor layer, a light emitting layer, a second semiconductor layer, a second electrode, a first insulating portion, and a first conductive layer. The first electrode includes a first region and a second region, the second region being arranged with the first region in a first direction. The first semiconductor layer of a first conductivity type is separated from the first region in a second direction intersecting the first direction. The first semiconductor layer includes a first portion and a second portion, the second portion being arranged with the first portion in a direction intersecting the second direction. The light emitting layer is provided between the second portion and the first region. The second semiconductor layer of a second conductivity type is provided between the light emitting layer and the first region. The second electrode is provided between the first region and the second semiconductor layer to contact the second semiconductor layer. The first insulating portion is provided between the first region and the second electrode. The first conductive layer is provided between the first portion and the first region. The first conductive layer includes a contact portion contacting the first portion. The first conductive layer is electrically connected to the first region. A first interface between the first portion and the contact portion is tilted with respect to a second interface between the second semiconductor layer and the second electrode.

Various embodiments will be described hereinafter with reference to the accompanying drawings.

The drawings are schematic or conceptual; and the relationships between the thicknesses and widths of portions, the proportions of sizes between portions, etc., are not necessarily the same as the actual values thereof. Further, the dimensions and/or the proportions may be illustrated differently between the drawings, even in the case where the same portion is illustrated.

In the drawings and the specification of the application, components similar to those described in regard to a drawing thereinabove are marked with like reference numerals, and a detailed description is omitted as appropriate.

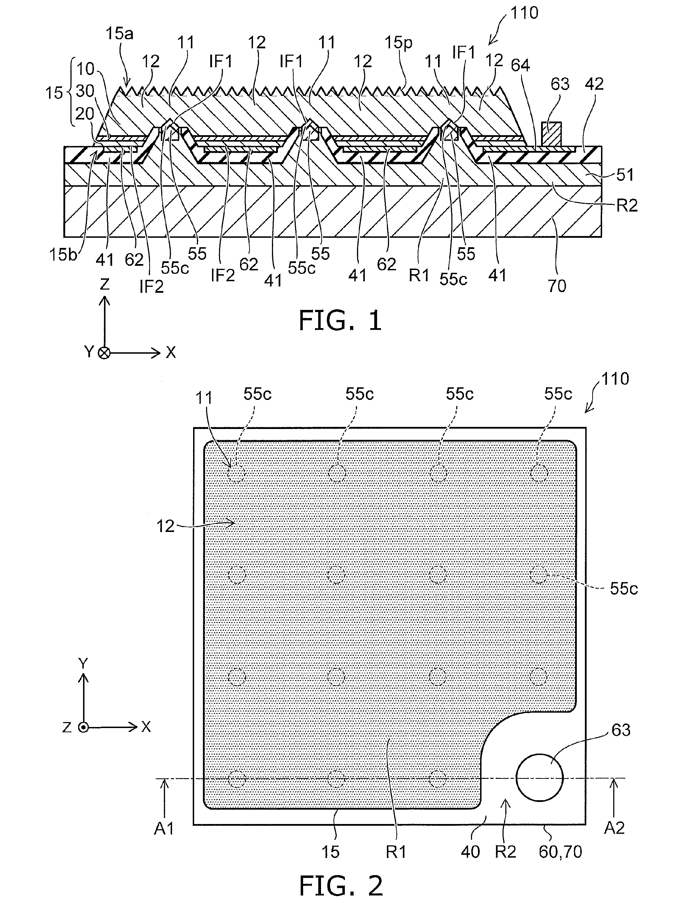

FIG. 1 is a schematic cross-sectional view illustrating a semiconductor light emitting element according to an embodiment.

FIG. 2 is a schematic plan view illustrating the semiconductor light emitting element according to the embodiment.

FIG. 1 shows the line A1-A2 cross section of FIG. 2.

As shown in FIG. 1 and FIG. 2, the semiconductor light emitting element 110 according to the embodiment includes a first electrode 51, a first semiconductor layer 10, a light emitting layer 30, a second semiconductor layer 20, a second electrode 62, a first insulating portion 41, and a first conductive layer 55.

The first semiconductor layer 10 is separated from the first electrode 51 in the Z-axis direction. One direction perpendicular to the Z-axis direction is taken as an X-axis direction. A direction perpendicular to the Z-axis direction and the X-axis direction is taken as a Y-axis direction.

The first electrode 51 extends in the X-Y plane. The first electrode 51 includes a first region R1 and a second region R2. The second region R2 is arranged with the first region R1 in the X-Y plane. For example, the second region R2 is arranged with the first region R1 in a first direction. The first direction is one direction in the X-Y plane.

The first semiconductor layer 10 is separated from the first region R1 in a second direction. The second direction intersects the first direction. The second direction is, for example, the Z-axis direction.

The first semiconductor layer 10 includes a first portion 11 and a second portion 12. The second portion 12 is arranged with the first portion 11 in a direction intersecting the second direction (the Z-axis direction). The first semiconductor layer 10 has a first conductivity type.

The light emitting layer 30 is provided between the second portion 12 and the first region R1.

The second semiconductor layer 20 is provided between the light emitting layer 30 and the first region R1. The second semiconductor layer 20 has a second conductivity type.

For example, the first conductivity type is an n-type; and the second conductivity type is a p-type. In the embodiment, the first conductivity type may be the p-type; and the second conductivity type may be the n-type. Hereinbelow, the first conductivity type is taken to be the n-type; and the second conductivity type is taken to be the p-type.

The second electrode 62 is provided between the first region R1 and the second semiconductor layer 20. The second electrode 62 contacts the second semiconductor layer 20.

The first insulating portion 41 is provided between the first region R1 and the second electrode 62.

The first conductive layer 55 is provided between the first portion 11 and the first region R1. The first conductive layer 55 includes a contact portion 55c. The contact portion 55c contacts the first portion 11. The first conductive layer 55 is electrically connected to the first region R1.

In the example, a third electrode 63, a second conductive layer 64, and a second insulating portion 42 are further provided. The third electrode 63 overlaps the second region R2 when projected onto the X-Y plane (a plane intersecting the second direction).

The second conductive layer 64 electrically connects the second electrode 62 to the third electrode 63. The second insulating portion 42 is provided between the third electrode 63 and the second region R2. The second insulating portion 42 is provided between the second conductive layer 64 and the second region R2.

In the example, a base unit 70 is further provided. The first electrode 51 is disposed between the base unit 70 and the first insulating portion 41. The base unit 70 includes a metal or a semiconductor.

The first semiconductor layer 10, the light emitting layer 30, and the second semiconductor layer 20 include, for example, nitride semiconductors.

The contact portion 55c is light-reflective. For example, the contact portion 55c includes aluminum.

The second electrode 62 is light-reflective. The second electrode 62 includes silver or a silver alloy.

The first semiconductor layer 10, the light emitting layer 30, and the second semiconductor layer 20 are included in a stacked unit 15. The stacked unit 15 has a first surface 15a and a second surface 15b. The second surface 15b is the surface on the first electrode 51 side. The first surface 15a is the surface on the side opposite to the second surface 15b.

In the example, an unevenness 15p is provided in the first surface 15a.

For example, a voltage is applied between the first electrode 51 (the base unit 70) and the third electrode 63. A current flows in the light emitting layer 30 via the first semiconductor layer 10 and the second semiconductor layer 20. Light is emitted from the light emitting layer 30. The light is emitted to the outside from the first surface 15a. The light extraction efficiency is increased by providing the unevenness 15p.

A portion of the light emitted by the light emitting layer 30 is reflected by the second electrode 62, travels toward the first surface 15a, and is emitted from the first surface 15a. Another portion of the light emitted by the light emitting layer 30 is reflected by the contact portion 55c, travels toward the first surface 15a, and is emitted from the first surface 15a.

For example, a first interface IF1 between the first portion 11 and the contact portion 55c is tilted with respect to the X-Y plane. On the other hand, a second interface IF2 between the second semiconductor layer 20 and the second electrode 62 is substantially parallel to the X-Y plane.

In other words, in the embodiment, the first interface IF1 is tilted with respect to the second interface IF2. The second interface IF2 is tilted with respect to the first interface IF1.

The angle between a plane including the first interface IF1 and a plane including the second interface IF2 is not less than 1 degree and not more than 75 degrees. Thereby, the practical thickness of the first semiconductor layer 10 and the practical surface area of the electrodes can be ensured. It is more favorable for the angle between the plane including the first interface IF1 and the plane including the second interface IF2 to be not less than 25 degrees and not more than 75 degrees. Thereby, lower contact resistance is obtained. An example of the relationship between the angle and the contact resistance is described below.

In the embodiment, the contact surface area between the first portion 11 and the contact portion 55c can be large by setting the first interface IF1 to be tilted with respect to the X-Y plane. The thermal resistance between the first portion 11 and the contact portion 55c decreases. A high thermal conductivity is obtained.

In the semiconductor light emitting element 110, the heat that is generated by the stacked unit 15 is transmitted to the base unit 70 via the first portion 11, the contact portion 55c, and the first electrode 51. The heat that is generated is dissipated efficiently by improving the thermal conductivity between the first portion 11 and the contact portion 55c. Thereby, the temperature increase of the stacked unit 15 can be suppressed. Thereby, a high luminous efficiency is obtained. According to the embodiment, a highly efficient semiconductor light emitting element can be provided.

The adhesion between the first portion 11 and the contact portion 55c is increased by setting the first interface IF1 to be tilted with respect to the X-Y plane. The reliability increases.

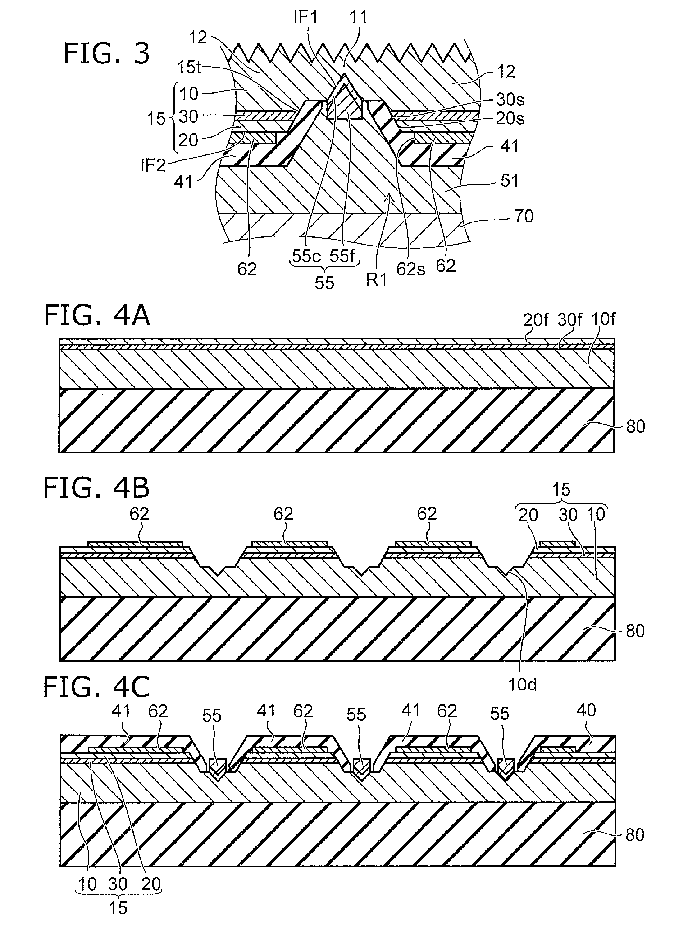

FIG. 3 is a schematic cross-sectional view illustrating a portion of the semiconductor light emitting element according to the embodiment.

In the semiconductor light emitting element 110 as shown in FIG. 3, the first conductive layer 55 further includes a conductive film 55f in addition to the contact portion 55c. The conductive film 55f is provided between the contact portion 55c and the first region R1.

Aluminum is used as the contact portion 55c. For example, a stacked structure including nickel and gold is used as the conductive film 55f. A low contact resistance and a high reflectance are obtained by using aluminum as the contact portion 55c.

In the embodiment, it is favorable for the surface area of the first interface IF1 to be large. The length along the second direction (the Z-axis direction) of the first interface IF1 is, for example, not less than 0.1 µm and not more than 10 µm.

The first insulating portion 41 covers the side surface of the second electrode 62. The first insulating portion 41 extends between the first electrode 51 and a side surface 20s of the second semiconductor layer 20 and between the side surface 30s of the light emitting layer 30 and the first electrode 51. The first insulating portion 41 extends between the first region R1 and a portion of the first portion 11. The first electrode 51 and the second semiconductor layer 20 are electrically isolated. The first electrode 51 and the light emitting layer 30 are electrically isolated.

For example, a side surface 15t of the stacked unit 15 is tilted with respect to the second interface IF2. Thereby, the coverage of the first insulating portion 41 improves. The insulative properties improve. The reliability can be increased.

The first electrode 51 includes a material for which a good connection with the base unit 70 can be obtained. For example, a stacked film of Ti/Au is used as the first electrode 51. The thickness of the stacked film is, for example, not less than 500 nm and not more than 1200 nm.

An example of a method for manufacturing the semiconductor light emitting element 110 will now be described.

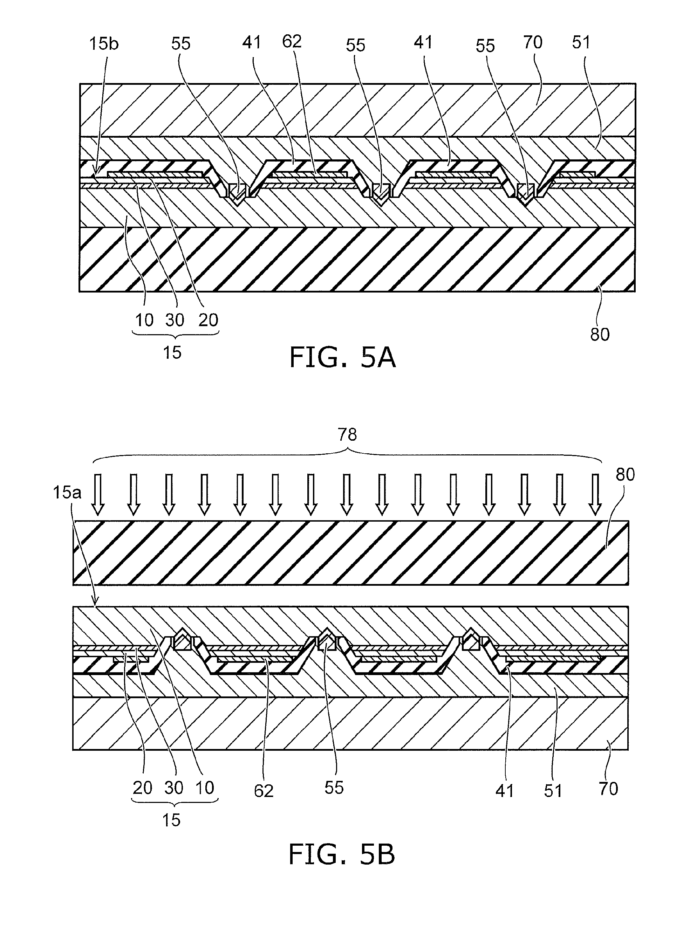

FIG. 4A to FIG. 4C, FIG. 5A, and FIG. 5B are schematic cross-sectional views in order of the processes, illustrating the method for manufacturing the semiconductor light emitting element according to the embodiment.

As shown in FIG. 4A, crystal growth of a first semiconductor film 10f that is used to form the first semiconductor layer 10, a light emitting film 30f that is used to form the light emitting layer 30, and a second semiconductor film 20f that is used to form the second semiconductor layer 20 is performed in order on a growth substrate 80. Thereby, the stacked unit 15 is formed on the growth substrate 80. The growth substrate 80 includes, for example, one of silicon, sapphire, GaN, or SiC. For example, the stacked unit 15 is formed using metal organic chemical vapor deposition.

As a buffer layer on the growth substrate 80 of which the surface is a sapphire c-plane, for example, a first AIN buffer layer having a high carbon concentration (having a carbon concentration of, for example, not less than 3×10¹⁸ cm⁻³ and not more than 5×10²⁰ cm⁻³ and a thickness of, for example, not less than 3 nm and not more than 20 nm), a high-purity second AIN buffer layer (having a carbon concentration of, for example, not less than 1×10¹⁶ cm⁻³ and not more than 3×10¹⁸ cm⁻³ and a thickness of 2 µm), and a non-doped GaN buffer layer (having a thickness of, for example, 2 µm) are formed in this order. The first AIN buffer layer and the second AIN buffer layer recited above are monocrystalline aluminum nitride layers.

A Si-doped n-type GaN contact layer (having a Si concentration of, for example, not less than 1×10¹⁸ cm⁻³ and not more than 5×10¹⁹ cm⁻³ and a thickness of 6 µm) and a Si-doped n-type Al_{0.10}Ga_{0.90}N clad layer (having a Si concentration of, for example, 1×10¹⁸ cm⁻³ and a thickness of 0.02 µm) are formed in this order on the buffer layer. The Si-doped n-type GaN contact layer and the Si-doped n-type Al_{0.10}Ga_{0.90}N clad layer are the first semiconductor film 10f.

As the light emitting film 30f, three periods of a Si-doped n-type Al_{0.11}Ga_{0.89}N barrier layer and a GaInN well layer are stacked alternately on the first semiconductor film 10f. Further, a final Al_{0.11}Ga_{0.89}N barrier layer having a multiple quantum well is stacked. For example, the Si concentration of the Si-doped n-type Al_{0.11}Ga_{0.89}N barrier layer is set to be not less than 1.1×10¹⁹ cm⁻³ and not more than 1.5×10¹⁹ cm⁻³. The final Al_{0.11}Ga_{0.89}N barrier layer has a Si concentration of, for example, not less than 1.1×10¹⁹ cm⁻³ and not more than 1.5×10¹⁹ cm⁻³ and a thickness of, for example, 0.01 µm. The thickness of such a multiple quantum well structure is, for example, 0.075 µm. Subsequently, a Si-doped n-type Al_{0.11}Ga_{0.89}N layer (having a Si concentration of, for example, not less than 0.8×10¹⁹ cm⁻³ and not more than 1.0×10¹⁹ cm⁻³ and a thickness of, for example, 0.01 µm) is formed. The wavelength of the light emitted by the light emitting film 30f is, for example, not less than 370 nm and not more than 480 nm or not less than 370 nm and not more than 400 nm.

As the second semiconductor film 20f, a non-doped Al_{0.11}Ga_{0.89}N spacer layer (having a thickness of, for example, 0.02 µm), a Mg-doped p-type Al_{0.28}Ga_{0.72}N clad layer (having a Mg concentration of, for example, 1×10¹⁹ cm⁻³ and a thickness of, for example, 0.02 µm), a Mg-doped p-type GaN contact layer (having a Mg concentration of, for example, 1×10¹⁹ cm⁻³ and a thickness of 0.4 µm), and a high-concentration Mg-doped p-type GaN contact layer (having a Mg concentration of, for example, 5×10¹⁹ cm⁻³ and a thickness of, for example, 0.02 µm) are sequentially formed in this order on the light emitting film 30f.

A portion of the stacked unit 15 is removed as shown in FIG. 4B. Thereby, the second semiconductor layer 20 is formed from the second semiconductor film 20f; the light emitting layer 30 is formed from the light emitting film 30f; and the first semiconductor layer 10 is formed from the first semiconductor film 10f. At this time, the side surface 15t of the stacked unit 15 is formed.

The side surface of a recess 10d provided in the first semiconductor film 10f is tilted. For example, RIE processing of the first semiconductor layer 10 is performed in, for example, a Cl₂-containing atmosphere. Thereby, the side surface of the recess 10d is tilted.

The second electrode 62 is formed on the second semiconductor layer 20. For example, a stacked film of Ag/Pt that is used to form an ohmic electrode is formed on the surface of the second semiconductor layer 20 to have a thickness of, for example, 200 nm. Subsequently, sintering is performed in an oxygen atmosphere at about 400 °C for 1 minute. For example, a stacked film of Ti/Au/Ti is formed on the ohmic electrode to have a thickness of, for example, 400 nm. The second electrode 62 is formed by patterning these films.

The first insulating portion 41 is formed as shown in FIG. 4C. The first insulating portion 41 covers the second electrode 62 and the side surface 15t. For example, a SiO₂ film having a thickness of not less than 600 nm and not more than 1200 nm is formed as the first insulating portion 41. The recess 10d of the first semiconductor layer 10 is exposed by removing a portion of the SiO₂ film.

The contact portion 55c is formed on the recess 10d. For example, a stacked film of, for example, Al/Ni/Au is formed as the contact portion 55c. The thickness of the stacked film is, for example, not less than 200 nm and not more than 400 nm. Thereby, the contact portion 55c is formed. For example, lift-off or the like is used to form the Al film. Heat treatment (sintering) of the Al film is performed at a temperature of 400 °C or less in a nitrogen atmosphere for about 1 minute (e.g., not less than 30 seconds and not more than 5 minutes).

The first electrode 51 is formed as shown in FIG. 5A. For example, a stacked film of Ti/Au is formed. The thickness of the stacked film is, for example, not less than 600 nm and not more than 1200 nm.

For example, the base unit 70 is bonded to the first electrode 51. For example, the base unit 70 includes a Ge substrate and a bonding film of AuSn provided on the Ge substrate. The bonding film is bonded to the first electrode 51.

As shown in FIG. 5B, laser light 78 is irradiated on the stacked unit 15 via the growth substrate 80. The laser light 78 is, for example, a third harmonic (355 nm) or fourth harmonic (266 nm) YVO₄ solid-state laser. The wavelength of the laser light 78 is shorter than a bandgap wavelength based on the bandgap of the GaN of the GaN buffer layer (e.g., the non-doped GaN buffer layer recited above). In other words, the energy of the laser light 78 is higher than the bandgap of GaN. The growth substrate 80 is separated from the stacked unit 15. The unevenness 15p is formed in the first surface 15a of the stacked unit 15.

Thereby, the semiconductor light emitting element 110 is formed.

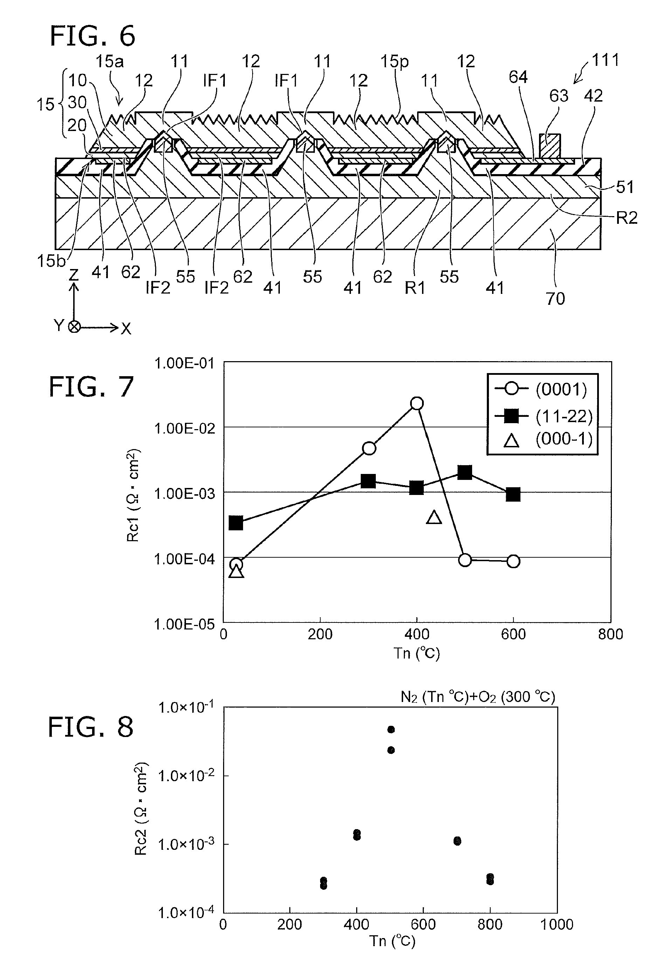

FIG. 6 is a schematic cross-sectional view illustrating another semiconductor light emitting element according to the embodiment.

In the semiconductor light emitting element 111 according to the embodiment as shown in FIG. 6, the first semiconductor layer 10 includes a portion in which the unevenness 15p is provided and a portion in which the unevenness 15p is not provided.

The portion in which the unevenness 15p is not provided overlaps the contact portion 55c when projected onto the X-Y plane. Thus, the unevenness 15p may be provided in a portion of the first surface 15a.

In the case where nitride semiconductors are used as the first semiconductor layer 10 and the second semiconductor layer 20 in the embodiment, the contact resistance can be reduced by setting the first interface IF1 to be a prescribed crystal plane.

FIG. 7 is a graph of characteristics of the semiconductor light emitting element according to the embodiment.

FIG. 7 illustrates experimental results of a contact resistance Rc1 for the case where the first interface IF1 is the (0001) plane, the case where the first interface IF1 is the (000-1) plane, and the case where the first interface IF1 is the (11-22) plane. The horizontal axis is a temperature Tn (°C) of the heat treatment. The vertical axis is the contact resistance Rc1 (Ω·cm²).

In the experiment, the surface of the first semiconductor layer 10 (the GaN) is patterned to be the surface recited above. Subsequently, RIE processing is performed. Subsequently, an Al film is formed on the surface of the first semiconductor layer 10. After forming the Al film, heat treatment is performed in a nitrogen atmosphere for 1 minute. The temperature of the heat treatment is modified to be in the range of 300 °C to 600 °C.

In FIG. 7, the temperature Tn of the heat treatment being 25 °C corresponds to the case where the heat treatment is not implemented. In the case of the (000-1) plane, ohmic contact was not obtained and the contact resistance Rc1 could not be calculated other than when the temperature Tn of the heat treatment was 25 °C and 450 °C.

It can be seen from FIG. 7 that in the range of 300 °C to 600 °C, the contact resistance Rc1 for the (11-22) plane is stable and low compared to that of the (0001) plane and that of the (000-1) plane. Thus, the thermal stability is high for the (11-22) plane.

For example, nitrogen vacancies disappear easily due to heat in the (0001) plane or the (000-1) plane. It is considered that the contact resistance Rc1 becomes high for this reason. Nitrogen vacancies form, for example, in the RIE processing. If the thermal stability of the nitrogen vacancies is low when the nitrogen vacancies form, this causes the contact resistance Rc1 to increase.

It is considered that nitrogen vacancies do not form easily in the (11-22) plane. It is considered that this improves the thermal stability of the contact resistance Rc1. Or, it may be considered that nitrogen vacancies form; and as a result, the contact resistance Rc1 has better thermal stability.

For example, it is considered that nitrogen vacancies stably exist in a semi-polar plane in which Ga and N are exposed at the surface. Thereby, it is considered that a low contact resistance is obtained for a wide range of heat treatment conditions for the (11-22) plane. For example, the (11-22) plane, the (1-101) plane, etc., can be used as the semi-polar plane.

For example, the first interface IF1 is set to be substantially the (11-22) plane. Thereby, a low contact resistance Rc1 is obtained.

On the other hand, high crystallinity is obtained easily by using the c-plane as the second interface IF2. For example, the second interface IF2 is substantially parallel to the c-plane of the first semiconductor layer 10 (or the c-plane of the second semiconductor layer 20). For example, the absolute value of the angle between the second interface IF2 and the c-plane of the first semiconductor layer 10 is 5 degrees or less.

On the other hand, the first interface IF1 is set to be substantially parallel to the (11-22) plane. For example, the absolute value of the angle between the first interface IF1 and the c-plane of the first semiconductor layer 10 is not less than 52.5 degrees and not more than 56.5 degrees. Thereby, a low contact resistance Rc1 is obtained.

In the embodiment, the first interface IF1 may be substantially parallel to the (1-101) plane. For example, the absolute value of the angle between the first interface IF1 and the c-plane of the first semiconductor layer 10 is not less than 60 degrees and not more than 64 degrees. A low contact resistance Rc1 is obtained.

In the embodiment, it is favorable for the first interface IF1 to be a semi-polar plane in the case where nitride semiconductors are included in the semiconductor layers. For example, the absolute value of the angle between the first interface IF1 and the c-plane of the first semiconductor layer 10 is not less than 50 degrees and not more than 70 degrees. In such a case, for example, the angle between the plane including the first interface IF1 and the plane including the second interface IF2 is not less than 50 degrees and not more than 70 degrees.

FIG. 8 is a graph of characteristics of the semiconductor light emitting element according to the embodiment.

FIG. 8 shows the relationship between the temperature of the heat treatment and a contact resistance Rc2 of the p-side electrode (the second electrode 62). The horizontal axis is the temperature Tn of the heat treatment. The vertical axis is the contact resistance Rc2.

In the example, a silver film having a thickness of 200 nm is used as the second electrode 62. The silver film is formed on the second semiconductor layer 20. Subsequently, a first heat treatment is performed in a nitrogen atmosphere. Further, a second heat treatment is performed in an oxygen atmosphere. For example, the first heat treatment corresponds to the heat treatment of the contact portion 55c. In the example, the first heat treatment is performed for 1 minute in the nitrogen atmosphere. The second heat treatment is performed for 1 minute at 300 °C in an atmosphere having not less than 20% oxygen.

From FIG. 8, the contact resistance Rc2 is extremely high in the range in which the temperature of the first heat treatment is not less than 500 °C and not more than 600 °C. It is favorable for the temperature of the first heat treatment to be less than 500 °C. It is favorable to be higher than 600 °C.

Practically, it is favorable for the temperature of the first heat treatment to be 400 °C or less. For example, a film that is used to form the p-side electrode (the second electrode 62) is formed; and heat treatment (sintering) of the film is performed. Subsequently, a film that is used to form the n-side electrode (the first conductive layer 55) is formed; and heat treatment (sintering) of the film is performed. The contact resistance of the p-side electrode undesirably increases in the case where the temperature of the heat treatment of the film used to form the n-side electrode is higher than 400 °C. Therefore, a low contact resistance is obtained for the p-side electrode by setting the temperature of the first heat treatment to be 400 °C or less.

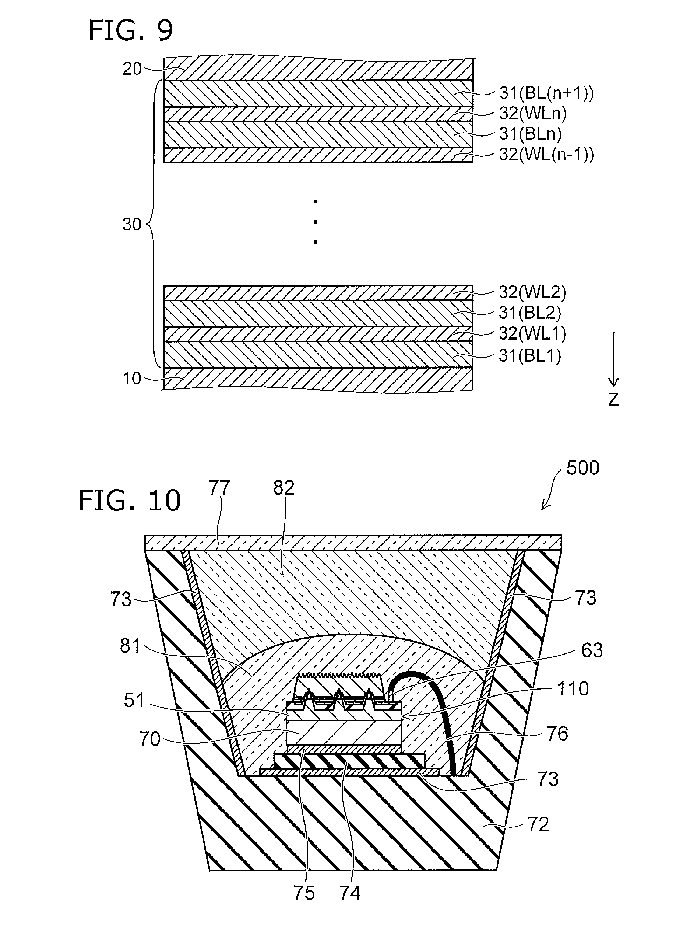

FIG. 9 is a schematic cross-sectional view illustrating a portion of the semiconductor device according to the embodiment.

As shown in FIG. 9, the light emitting layer 30 includes multiple barrier layers 31, and a well layer 32 provided between the multiple barrier layers 31. For example, the multiple barrier layers 31 and the multiple well layers 32 are stacked alternately along the Z-axis.

The well layer 32 includes In*ₓ₁*Ga_{1-*x1*}N (0 < *x1* < 1). The barrier layer 31 includes GaN. In other words, the well layer 32 includes In; and the barrier layer 31 substantially does not include In. The bandgap energy of the barrier layer 31 is larger than the bandgap energy of the well layer 32.

The light emitting layer 30 may have a single quantum well (SQW) configuration. In such a case, the light emitting layer 30 includes two barrier layers 31, and the well layer 32 provided between the barrier layers 31. Or, the light emitting layer 30 may have a multiple quantum well (MQW) configuration. In such a case, the light emitting layer 30 includes three or more barrier layers 31 and the well layers 32 provided in each space between the barrier layers 31.

In other words, the light emitting layer 30 includes *n*+1 barrier layers 31 and *n* well layers 32 (*n* being an integer not less than 8). The (*i*+1)th barrier layer BL(*i*+1) is disposed between the *i*th barrier layer BL*i* and the second semiconductor layer 20 (*i* being an integer not less than 1 and not more than *n*-1). The (*i*+1)th well layer WL(*i*+1) is disposed between the *i*th well layer WL*i* and the second semiconductor layer 20. The first barrier layer BL1 is provided between the first semiconductor layer 10 and the first well layer WL1. The *n*th well layer WL*n* is provided between the *n*th barrier layer BL*n* and the (*n*+1)th barrier layer BL(*n*+1). The (*n*+1)th barrier layer BL(*n*+1) is provided between the *n*th well layer WLn and the second semiconductor layer 20.

The peak wavelength of the light (the emitted light) emitted from the light emitting layer 30 is, for example, not less than 360 nm and not more than 650 nm. However, in the embodiment, the peak wavelength is arbitrary.

FIG. 10 is a schematic cross-sectional view illustrating a light emitting device using the semiconductor light emitting element according to the embodiment.

Although the semiconductor light emitting element 110 is used in the example, the semiconductor light emitting element 111 or a modification of these elements may be used.

The light emitting device 500 includes the semiconductor light emitting element 110, and a fluorescent material that absorbs the light emitted from the semiconductor light emitting element 110 and emits light of a wavelength different from that of the absorbed light.

For example, a reflective film 73 is provided on the inner surface of a container 72 of a ceramic, etc. The reflective film 73 is provided separately on the inner side surface and bottom surface of the container 72. For example, aluminum is used as the reflective film 73. The semiconductor light emitting element 110 is mounted on the reflective film 73 provided at the bottom portion of the container 72 with a submount 74 interposed between the semiconductor light emitting element 110 and the reflective film 73.

For example, the base unit 70 is fixed to the submount 74 using low-temperature solder. A bonding agent may be used for the fixation.

An electrode 75 is provided on the surface of the submount 74 on the semiconductor light emitting element 110 side. The base unit 70 of the semiconductor light emitting element 110 is mounted on the electrode 75. A bonding wire 76 is connected to the third electrode 63.

For example, a first fluorescent material layer 81 that includes a red fluorescent material is provided to cover the semiconductor light emitting element 110 and the bonding wire 76. A second fluorescent material layer 82 that includes a blue, green, or yellow fluorescent material is provided on the first fluorescent material layer 81. For example, a cover 77 of a silicone resin, etc., is provided on the fluorescent material layer.

The first fluorescent material layer 81 includes a resin, and a red fluorescent material dispersed in the resin. The second fluorescent material layer 82 includes a resin, and at least one of a blue, green, or yellow fluorescent material dispersed in the resin. For example, a fluorescent material may be used in which a blue fluorescent material and a green fluorescent material are combined. A fluorescent material may be used in which a blue fluorescent material and a yellow fluorescent material are combined. A fluorescent material may be used in which a blue fluorescent material, a green fluorescent material, and a yellow fluorescent material are combined.

In the light emitting device 500, for example, ultraviolet light of a wavelength of 380 nm that is emitted from the semiconductor light emitting element 110 is emitted upward from the semiconductor light emitting element 110. The wavelength is converted by the wavelength conversion layer; and, for example, white light is obtained.

Other than metal organic chemical vapor deposition, the formation of the stacked unit 15 may be performed using molecular beam epitaxy, etc.

The base unit 70 may include a semiconductor substrate of Ge, Si, etc. The base unit 70 may include a metal plate of Cu, CuW, etc.

According to the embodiment, a highly efficient semiconductor light emitting element is provided.

In the specification, "nitride semiconductor" includes all compositions of semiconductors of the chemical formula B*ₓ*In*_{y}*Al*_{z}*Ga_{1-*x-y*-*z*}N (0 ≤ *x* ≤ 1,0 ≤ *y* ≤ 1, 0 ≤ *z* ≤ 1, and *x*+*y*+*z* ≤ 1) for which the composition ratios x, y, and z are changed within the ranges respectively. "Nitride semiconductor" further includes group V elements other than N (nitrogen) in the chemical formula recited above, various elements added to control various properties such as the conductivity type and the like, and various elements included unintentionally.

In the specification of the application, "perpendicular" and "parallel" include not only strictly perpendicular and strictly parallel but also, for example, the fluctuation due to manufacturing processes, etc.; and it is sufficient to be substantially perpendicular and substantially parallel.

Hereinabove, embodiments of the invention are described with reference to specific examples. However, the invention is not limited to these specific examples. For example, one skilled in the art may similarly practice the invention by appropriately selecting specific configurations of components included in the semiconductor light emitting element such as the semiconductor layers, the electrodes, the conductive layers, the insulating portions, the base unit, etc., from known art; and such practice is within the scope of the invention to the extent that similar effects can be obtained.

Further, any two or more components of the specific examples may be combined within the extent of technical feasibility and are included in the scope of the invention to the extent that the purport of the invention is included.

Moreover, all semiconductor light emitting elements practicable by an appropriate design modification by one skilled in the art based on the semiconductor light emitting elements described above as embodiments of the invention also are within the scope of the invention to the extent that the spirit of the invention is included.

Various other variations and modifications can be conceived by those skilled in the art within the spirit of the invention, and it is understood that such variations and modifications are also encompassed within the scope of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A semiconductor light emitting element (110, 111), comprising:
a first electrode (51) including a first region (R1) and a second region (R2), the second region (R2) being arranged with the first region (R1) in a first direction;
a first semiconductor layer (10) of a first conductivity type separated from the first region (R1) in a second direction intersecting the first direction, the first semiconductor layer (10) including a first portion (11) and a second portion (12), the second portion (12) being arranged with the first portion (11) in a direction intersecting the second direction;
a light emitting layer (30) provided between the second portion (12) and the first region (R1);
a second semiconductor layer (20) of a second conductivity type provided between the light emitting layer (30) and the first region (R1);
a second electrode (62) provided between the first region (R1) and the second semiconductor layer (20) to contact the second semiconductor layer (20);
a first insulating portion (41) provided between the first region (R1) and the second electrode (62); and
a first conductive layer (55) provided between the first portion (11) and the first region (R1), the first conductive layer (55) including a contact portion (55c) contacting the first portion (11), the first conductive layer (55) being electrically connected to the first region (R1),
a first interface (IF1) between the first portion (11) and the contact portion (55c) being tilted with respect to a second interface (IF2) between the second semiconductor layer (20) and the second electrode (62).

2. The element (110, 111) according to claim 1, wherein an angle between a plane including the first interface (IF1) and a plane including the second interface (IF2) is not less than 1 degree and not more than 75 degrees.

3. The element (110, 111) according to claim 1, wherein
the first semiconductor layer (10) includes a nitride semiconductor, and
the second semiconductor layer (20) includes a nitride semiconductor.

4. The element (110, 111) according to claim 1, wherein an angle between a plane including the first interface (IF1) and a plane including the second interface (IF2) is not less than 25 degrees and not more than 75 degrees.

5. The element (110, 111) according to one of claims 3 and 4, wherein an absolute value of an angle between the second interface (IF2) and a c-plane of the first semiconductor layer (10) is 5 degrees or less.

6. The element (110, 111) according to one of claims 3-5, wherein an absolute value of an angle between the first interface (IF1) and a c-plane of the first semiconductor layer (10) is not less than 50 degrees and not more than 70 degrees.

7. The element (110, 111) according to one of claims 3-5, wherein an absolute value of an angle between the first interface (IF1) and a c-plane of the first semiconductor layer (10) is not less than 52.5 degrees and not more than 56.5 degrees.

8. The element (110, 111) according to one claims 3-5, wherein an absolute value of an angle between the first interface (IF1) and a c-plane of the first semiconductor layer (10) is not less than 60 degrees and not more than 64 degrees.

9. The element (110, 111) according to one of claims 1-8, wherein the contact portion (55c) includes aluminum.

10. The element (110, 111) according to one of claims 1-9, wherein the first conductive layer (55) further includes a conductive film (55f) provided between the contact portion (55c) and the first region (R1).

11. The element (110, 111) according to one of claims 1-10, wherein the second electrode (62) includes silver.

12. The element (110, 111) according to one of claims 1-11, further comprising:
a third electrode (63) overlapping the second region (R2) when projected onto a plane intersecting the second direction;
a second conductive layer (64) electrically connecting the second electrode (62) to the third electrode (63); and
a second insulating portion (42) provided between the second conductive layer (62) and the second region (R2).

13. The element (110, 111) according to one of claims 1-12, wherein the first insulating portion (41) covers a side surface of the second electrode (62).

14. The element (110, 111) according to one of claims 1-13, wherein the first insulating portion (41) extends between the first electrode (51) and a side surface (20s) of the second semiconductor layer (20) and between the first electrode (51) and a side surface (30s) of the light emitting layer (30).

15. The element (110, 111) according to one of claims 1-14, wherein the first insulating portion (41) extends between the first region (R1) and a portion of the first portion (11).

16. The element (110, 111) according to one of claims 1-15, wherein a side surface (15t) of a stacked unit (15) including the first semiconductor layer (10), the second semiconductor layer (20), and the light emitting layer (30) is tilted with respect to the second interface (IF2).

17. The element (110, 111) according to one of claims 1-16, further comprising a base unit (70),
the first electrode (51) being disposed between the base unit (70) and the first insulating portion (41).

18. The element (110, 111) according to claim 17, wherein the base unit (70) is a metal or a semiconductor.

19. The element (110, 111) according to one of claims 1-18, wherein a length along the second direction of the first interface (If1) is not less than 0.1 µm and not more than 10 µm.
